# EUROPEAN PATENT APPLICATION

(11) **EP 1 315 230 A1**
(43) Date of publication of application: **28.05.2003**
(21) Application number: 00956812.2
(22) Date of filing: 30.08.2000
(51) Int. Cl.: H01P 3/08, H01L 27/04

(54) **HIGH-FREQUENCY LINE AND HIGH-FREQUENCY CIRCUIT**

(71) Applicant: MITSUBISHI DENKI KABUSHIKI KAISHA, Tokyo 100-8310 (JP)
(72) Inventor: TAJIMA, Kenichi, Mitsubishi Denki Kabushiki Kaisha, Tokyo 100-8310 (JP); TSURU, Masaomi, Mitsubishi Denki Kabushiki Kaisha, Tokyo 100-8310 (JP); UESUGI, Mikio, Mitsubishi Denki Kabushiki Kaisha, Tokyo 100-8310 (JP); ITOH, Kenji, Mitsubishi Denki Kabushiki Kaisha, Tokyo 100-8310 (JP); ISOTA, Yoji, Mitsubishi Denki Kabushiki Kaisha, Tokyo 100-8310 (JP)
(74) Representative: Pfenning, Meinig & Partner
(86) International application number: JP0005880
(87) International publication number: WO02019461

(57) **Abstract**

A high-frequency line for high-frequency signals of the microwave band or millimeter wave band is composed of a semiconductor substrate 21, a grounding conductor 22 formed on the underside of the semiconductor substrate 21, an insulator 23 formed on the top of the semiconductor substrate 21 and having an effective dielectric constant higher than that of the semiconductor substrate 21, and a strip conductor 25 provided in a groove formed in the top of the insulator 23 and having a concavely curved configuration that the central surface area of the strip conductor is lower than its marginal portions.

## Description

### TECHNICAL FIELD

The present invention relates to a high-frequency line formed on a semiconductor substrate for operation with high-frequency signals of the microwave or millimeter wave band and a high-frequency circuit formed using the high-frequency line and, more particularly, to a high-frequency line and a high-frequency circuit that achieve low power loss operations.

### BACKGROUND ART

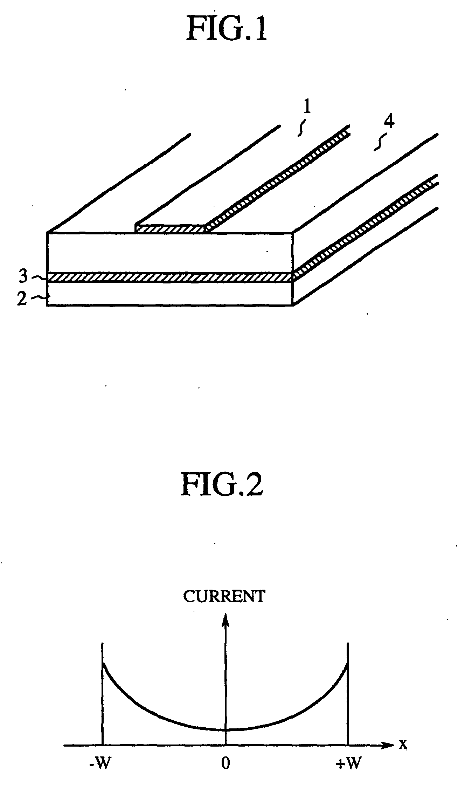

Fig. 1 is a perspective view showing the construction of a conventional microstrip line used in a transmitter-receiver for microwave and millimeter wave bands. In Fig. 1, reference numeral 1 denotes a strip conductor, 2 a semiconductor substrate, 3 a grounding conductor, and 4 an insulator.

Next, the operation of the microstrip line depicted in Fig. 1 will be described. Between the strip conductor 1 and the grounding conductor 3 electric lines of force are oriented almost vertically, whereas near the end face of the strip conductor 1 electric lines of force are radiated into space above the substrate. With such a microstrip line, energy propagates mostly between the strip conductor 1 and the grounding conductor 3, causing a conductor loss attributable to the electric lines of force emanating from around the end face of the strip conductor 1.

Fig. 2 is a graph showing the amount of current flow in the widthwise direction of the strip conductor of such a microstrip line as depicted in Fig. 1. In Fig. 2, reference character W denotes a length one-half the width of the strip conductor 1, and the point given by the coordinate value 0 in the X-axis direction corresponds to the center of the strip conductor 1. As shown in Fig. 2, the high-frequency current flow in the strip conductor 1 centers on marginal portions of the strip conductor 1. As described above, electric lines of force are liable to be radiated into space from the strip conductor 1 near its marginal portions, and the conductor loss increases with an increase in the amount of current flow to the marginal portions.

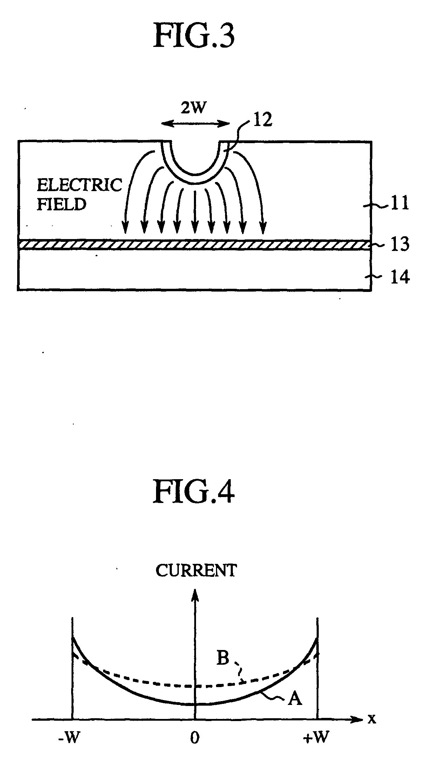

Many studies have been made to combat the problem of transmission loss in such a microstrip line as mentioned above; for example, "Characteristics of U-grooved Microstrip Lines" (1994 Spring National Convention of Institute of Electronics, Information and Communication Engineers of Japan, C-144) and other studies have been disclosed. Fig. 3 is a cross-sectional view depicting the construction of a microstrip line provided with a U-shaped strip conductor according to the above-mentioned disclosure. In Fig. 3, reference numeral 11 denotes an insulator having cut in its top a U-shaped groove, 12 a strip conductor formed over the entire area of the surface of the groove cut in the insulator 11) 13 a grounding conductor, and 14 a semiconductor substrate. Let it be assumed that the strip conductor 12 has a 2-W width in a horizontal direction.

Fig. 4 is a graph showing the amounts of current flowing widthwise of strip conductors in the microstrip lines of Figs. 1 and 3. In Fig. 4, the solid line marked with A indicates the current flow in the strip conductor 12 of the microstrip line of the Fig. 1 configuration, and the broken line marked with B indicates the current flow in the strip conductor 12 of the microstrip line of the Fig. 3 configuration. As depicted in Fig. 4, the strip conductor 12 formed all over the surface of the U-shaped groove suppresses centering of current on the marginal portions of the strip conductor 12, permitting reduction of the conductor loss.

As compared with the microstrip line of Fig. 1, the microstrip line of Fig. 3 causes a decrease in the density of electric lines of force passing through the air but an increase in the density of electric lines of force passing through the insulator 11. That is, the microstrip line of Fig. 3 has the problem of increased insulator loss. Further, since only the insulator 11 is interposed between the strip conductor 12 and the grounding conductor 13, the above prior art example is incapable of adjusting the insulator loss attributable to the electric line of force passing through the insulator 11.

Further, when the conventional microstrip line of the Fig. 1 or 3 configuration is used to form an open-circuit stub or short-circuit stub that provides a capacitive or inductive frequency characteristic, the prior art has a defect that a transmission loss is caused by the conductor loss or insulator loss of the microstrip line.

Moreover, when the conventional microstrip line of the Fig. 1 or 3 configuration is used to form a spiral inductor, a transmission loss is caused by the conductor loss or insulator loss of the microstrip line. And, when the spiral inductor having such a transmission loss is applied to such a high-frequency device as a high-frequency amplifier or high-frequency oscillator, the noise characteristic of the high-frequency device deteriorates.

The present invention is intended to solve such problems as mentioned above, and has for its object to provide a low-loss high-frequency line whose overall transmission loss is reduced by suppressing the conductor and insulator losses, and a high-frequency circuit formed using the high-frequency line.

### DISCLOSURE OF THE INVENTION

A high-frequency line according to an aspect of the present invention is provided with: a dielectric; a grounding conductor formed on the underside of the dielectric; an insulator formed on the top of the dielectric and having an effective dielectric constant higher than that of the dielectric; and a strip conductor formed in a groove formed in the top of the insulator and having a concavely curved configuration that the central surface area of the strip conductor is lower than its marginal portions.

With the above construction, it is possible to suppress the insulator loss through separation of the strip conductor and the grounding conductor not only by the insulator but also by the semiconductor substrate of an effective dielectric constant lower than that of the insulator, and the implementation of the optimum design on the microstrip line configuration through the use of an electromagnetic field simulator or the like provides an appropriate current distribution of the high-frequency current flowing through the strip conductor to reduce centering of the current flow on its either marginal portion, allowing suppression of the conductor loss and consequently enabling the transmission loss of the microstrip line to be reduced as a whole.

A high-frequency line according to another aspect of the present invention is provided with: a dielectric; a grounding conductor formed on the underside of the dielectric; a plurality of flat insulators of different dielectric constants higher than that of the dielectric and laminated in stepwise form on the top of the dielectric to form a groove; and a strip conductor provided in the groove defined by the plurality of insulators and having a concavely curved configuration that the central surface area of the strip conductor is lower than its marginal portions.

With the above construction, the insulator loss by the electric lines of force emanating from the strip conductor to the grounding conductor can be suppressed by interposing between the strip conductor and the grounding conductor not only the insulator parts but also the semiconductor substrate of an effective dielectric constant lower than that of the insulator parts; furthermore, by optimizing the configuration of the microstrip line through the use of an electromagnetic field simulator or the like, it is possible to avoid centering of the current flow in the strip conductor on its marginal portions to provide an appropriate current distribution, permitting suppression of the conductor loss. Moreover, the groove is formed approximately curved or straight by a suitable lamination of the insulators--this eliminates the need for three-dimensional processing and hence permits implementation of easy and low-cost fabrication of the microstrip line. Besides, individual selections of the effective dielectric constants of the flat insulators allow ease in optimizing the distribution of the high-frequency current.

A high-frequency line according to another aspect of the present invention is provided with: a dielectric; a grounding conductor formed on the underside of the dielectric; one or more first insulators formed on the top of the dielectric and having an effective dielectric constant higher than that of the dielectric; and a laminate formed concavely curved in its entirety by alternately laminating pluralities of strip conductors and second insulators in a groove formed in the top of the first insulator.

With the above construction, the insulator loss by the electric lines of force emanating from the strip conductor to the grounding conductor can be suppressed by interposing between the laminate formed as one strip conductor and the grounding conductor not only the insulator parts but also the semiconductor substrate of an effective dielectric constant lower than that of the insulator parts. Further, since the laminate is formed by alternately laminating the strip conductors and the second insulators, it is possible to suppress centering of the high-frequency current due to the skin effect in the strip conductors, reducing the conductor loss related to the strip conductors. Moreover, since end faces and corner portions of the laminate that can be handled as one strip conductor can be formed approximately curved by suitably selecting the widths of the strip conductors and the second insulators to be laminated alternately with each other, it is possible to suppress the emanation of electric lines of force at the marginal end portions of the strip conductors, thus reducing the transmission loss.

A high-frequency line according to another aspect of the present invention is provided with one or more through holes for electrically interconnecting the plurality of strip conductors forming the laminate.

With the above construction, it is possible to optimize the current distribution of the high-frequency current flow in the strip conductors forming the laminate, thereby reducing the conductor loss.

A high-frequency circuit according to another aspect of the present invention a construction in which a main line formed using any one of the above-mentioned lines is connected to one or more stubs each formed by said high-frequency line.

With the above construction, it is possible to obtain a low-loss high-frequency circuit that has a capacitive or inductive frequency characteristic. Further, when applied to such high-frequency devices as a high-frequency amplifier and a high-frequency oscillator, the high-frequency circuit will improve their noise characteristic.

A high-frequency circuit according to still another aspect of the present invention is provided with a spiral inductor formed using any one of the above-mentioned high-frequency lines.

With the above construction, it is possible to provide a high-frequency circuit having a low-loss spiral inductor. Further, when applied to such high-frequency devices as a high-frequency amplifier and a high-frequency oscillator, the high-frequency circuit will improve their noise characteristic.

### BRIEF DESCRIPTION OF THE DRAWINGS

Fig. 1 is a perspective view showing an example of a conventional microstrip line structure.
Fig. 2 is a graph showing the amount of current flowing widthwise of a strip conductor.
Fig. 3 is a cross-sectional view showing another example of a conventional microstrip line structure.
Fig. 4 is a graph showing the amount of current flowing widthwise of a strip conductor.
Fig. 5 is a cross-sectional view illustrating a microstrip line structure according to Embodiment 1 of the present invention.
Fig. 6 is a graph showing the amount of current flowing widthwise of a strip conductor.
Fig. 7 is a cross-sectional view illustrating a modified form of the microstrip line structure according to Embodiment 1 of the present invention.
Fig. 8 is a cross-sectional view illustrating a microstrip line structure according to Embodiment 2 of the present invention.
Fig. 9 is a cross-sectional view illustrating a microstrip line structure according to Embodiment 3 of the present invention.
Fig. 10 is a cross-sectional view illustrating a modified form of the microstrip line structure according to Embodiment 4 of the present invention.
Fig. 11 is a plan view illustrating an example of a high-frequency circuit according to Embodiment 5 of the present invention.
Fig. 12 is a plan view illustrating a modified form of the high-frequency circuit according to Embodiment 5 of the present invention.
Fig. 13 is a plan view illustrating an example of a high-frequency circuit according to Embodiment 6 of the present invention.

### BEST MODE FOR CARRYING OUT THE INVENTION

To clarify the present invention in more detail, the best mode for carrying out the invention will be described with reference to the accompanying drawings.

### EMBODIMENT 1

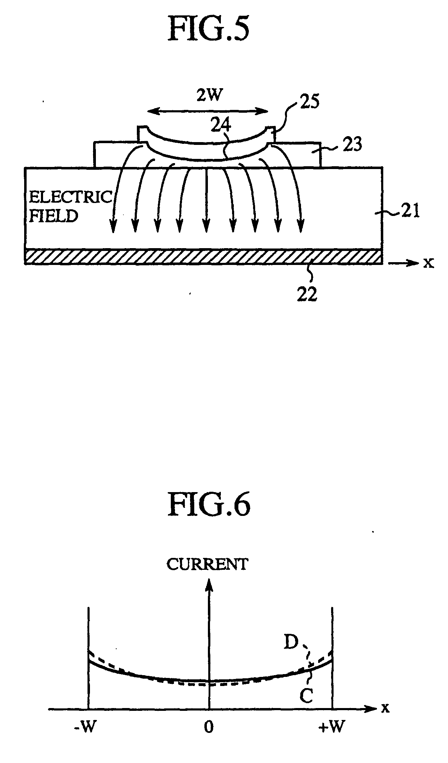

Fig. 5 is a cross-sectional view showing the construction of a microstrip line (a high-frequency line) according to Embodiment 1 of the present invention. In Fig. 5, reference numeral 21 denotes a semiconductor substrate (a dielectric); 22 denotes a grounding conductor formed on the underside of the semiconductor substrate 21; 23 denotes an insulator overlying the semiconductor substrate 21 and having an effective dielectric constant higher than that of the semiconductor substrate 21; 24 denotes a groove formed in the top of the insulator 23; and 25 denotes a strip conductor formed to about the same thickness by etching or similar printing process in the groove 24 of the insulator 23 and having its marginal portions extended to the outside of the groove 24. Since the groove 24 is concavely curved, the upper and lower edges of the strip conductor 25 are similarly curved as viewed in a cross-section; accordingly, the strip conductor 25 has a concave configuration that the distance between the central portion of the strip conductor 25 and the grounding conductor 22 is shorter than the distance between either side edge of the strip conductor 25 and the grounding conductor 22. Incidentally, the strip conductor 25 is assumed to have a width of 2 W.

Next, the operation of this embodiment will be described below. In the microstrip line of Embodiment 1 the strip conductor 25 and the grounding conductor 22 are separated not only by the insulator 23 but also by the semiconductor substrate 21 having an effective dielectric constant than does the insulator 23--this permits suppression of the insulator loss that is caused by the electric lines of force passing between the strip conductor 25 and the grounding conductor 22. Further, the microstrip line of the construction that has the semiconductor substrate 21 and the insulator 23 interposed between the strip conductor 25 and the grounding conductor 22 is optimally designed by means of an electromagnetic field simulator or the like to suppress centering of current flow on either marginal portions of the strip conductor 25. This provides an appropriate current distribution of the high-frequency current flowing through the strip conductor 25, which reduces centering of the current flow on its either marginal portion and hence suppresses the conductor loss.

Fig. 6 is a graph showing the amounts of current flowing widthwise of the strip conductor in the Fig. 3 conventional microstrip line and the Fig. 5 microstrip line according to Embodiment 1 of the present invention. In Fig. 6 the solid line marked with reference character C indicates the current flow in the strip conductor of the microstrip line of the Fig. 5 construction and the broken line marked with reference character D indicates the current flow in the strip conductor of the microstrip line of the fig. 3 construction. As depicted in Fig. 6, the separation of the strip conductor 25 and the grounding conductor 22 by the insulator 23 and the semiconductor substrate 23 of an effective dielectric constant lower than that of the insulator 23 suppresses centering of the current flow on the marginal portions of the strip conductor 25, permitting reduction of the conductor loss.

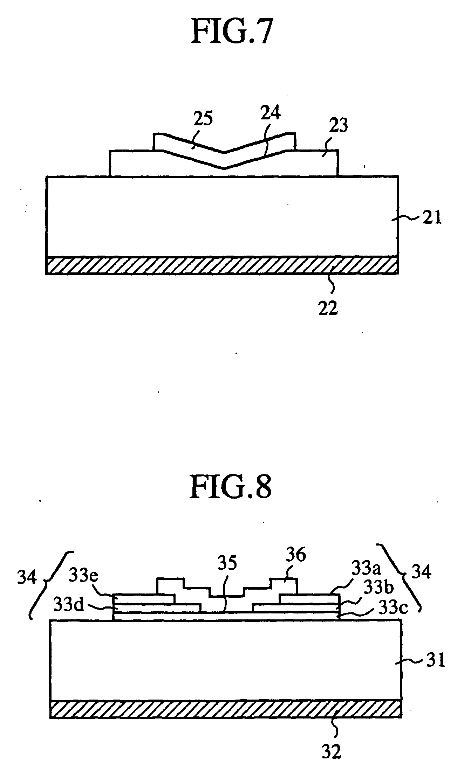

Fig. 7 is a cross-sectional view showing the construction of a modified form of the microstrip line according to Embodiment 1 of the present invention. In Fig. 7 the same reference numerals as those in Fig. 5 denote identical or corresponding parts, and no description will be repeated. The microstrip line of Fig. 7 differs from the microstrip line of Embodiment 1 in that the groove 24 of the insulator 23 is formed straight and that the upper and lower edges of the strip conductor 25 are similarly straight as viewed in a cross-section. With this structure, too, it is possible to suppress the insulator loss through separation of the strip conductor 25 and the grounding conductor 22 not only by the insulator 23 but also by the semiconductor substrate 21 of an effective dielectric constant lower than that of the insulator 23, and the optimum design of the microstrip line configuration through the use of an electromagnetic field simulator or the like provides an appropriate current distribution of the high-frequency current flowing through the strip conductor 25--this permits reduction of centering of the current flow on its either marginal portion, allowing suppression of the conductor loss.

As described above, according to Embodiment 1, the microstrip line is composed of the semiconductor substrate 21, the grounding conductor 22 underlying the semiconductor substrate 21, the insulator 23 overlying the semiconductor substrate 21 and having an effective dielectric constant higher than that of the semiconductor substrate 21, and the concavely curved strip conductor 24 formed concavely curved in the groove 24 in the top of the insulator 23 so that the central surface area of the strip conductor is lower than its marginal portions; hence, it is possible to suppress the insulator loss through separation of the strip conductor 25 and the grounding conductor 22 not only by the insulator 23 but also by the semiconductor substrate 21 of an effective dielectric constant lower than that of the insulator 23, and the implementation of the optimum design on the microstrip line configuration through the use of an electromagnetic field simulator or the like provides an appropriate current distribution of the high-frequency current flowing through the strip conductor 25 to reduce centering of the current flow on its either marginal portion, allowing suppression of the conductor loss and consequently enabling the transmission loss of the microstrip line to be reduced as a whole.

### EMBODIMENT 2

Fig. 8 is a cross-sectional view showing the construction of a microstrip line (a high-frequency line) according to Embodiment 2 of the present invention. In Fig. 8, reference numeral 31 denotes a semiconductor substrate (a dielectric); 32 denotes a grounding conductor formed on the underside of the semiconductor substrate 31; 33a, 33b, 33c, 33d and 33e denote flat insulators laminated on the top of the semiconductor substrate 31 and having different effective dielectric constants, widths and thicknesses; 34 denotes insulator parts formed by the lamination of the semiconductors 33a, 33b, 33c, 33d and 33e and having an effective dielectric constant higher than that of the semiconductor substrate 21; 35 denotes a groove 35 defined between the insulator parts 34 by the stepwise lamination of the flat insulators 33a, 33b, 33c, 33d and 33e; and 36 denotes a strip conductor formed to about the same thickness in the groove 35 between the insulator parts 34 by etching or similar printing process and having its marginal portions extended to the outside of the groove 35. By suitably setting the number of insulators 33 and their lamination, the groove 35 can be formed approximately curved or straight, and the upper and lower edges of the strip conductor 36 are also approximately curved or straight as viewed in a cross-section; hence, the strip conductor 36 has a concave configuration that the distance between its central portion and the grounding conductor 32 is shorter than the distance between either marginal portion of the strip conductor 36 and the grounding conductor 32.

Next, the operation of this embodiment will be described below. Such parameters as the effective dielectric constants, widths and thicknesses of the flat insulators 33a, 33b, 33c, 33d and 33e formed one on another between the strip conductor 36 and the semiconductor substrate 31 are optimized using an electromagnetic field simulator to provide an appropriate distribution of the high-frequency current flowing in the strip conductor 36.

As described above, according to Embodiment 2, since the microstrip line is composed of the semiconductor substrate 31, the grounding conductor 32 formed on the underside of the semiconductor substrate 31, the flat insulators 33a, 33b, 33c, 33d laminated on the top of the semiconductor substrate 31 and having different effective dielectric constants higher than that of the semiconductor substrate 31, the groove 35 defined by the stepwise lamination of the insulators 33e; 33a, 33b, 33c, 33d and 33e, and the strip conductor 36 formed concavely curved in the groove 35 so that the central surface area of the strip conductor is lower than its marginal portions, the insulator loss by the electric lines of force emanating from the strip conductor 36 to the grounding conductor 32 can be suppressed by interposing between the strip conductor 36 and the grounding conductor 32 not only the insulator parts 34 but also the semiconductor substrate 31 of an effective dielectric constant lower than that of the insulator parts 34; furthermore, by optimizing the configuration of the microstrip line through the use of an electromagnetic field simulator or the like, it is possible to avoid centering of the current flow in the strip conductor 36 on its marginal portions to provide an appropriate current distribution, permitting suppression of the conductor loss. Moreover, the microstrip line according to Embodiment 2 enables the groove 3 to be formed approximately curved or straight by a suitable lamination of the insulators 33a, 33b, 33c, 33d and 33e--this eliminates the need for three-dimensional processing and hence permits implementation of easy and low-cost fabrication of the microstrip line. Besides, individual selections of the effective dielectric constants of the flat insulators 33a, 33b, 3c, 33d and 33e allow ease in optimizing the distribution of the high-frequency current.

### EMBODIMENT 3

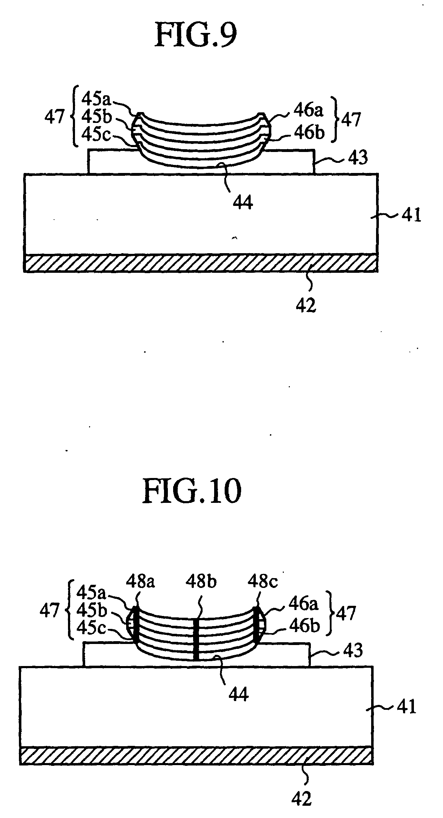

Fig. 9 is a cross-sectional view the construction of a microstrip line (a high-frequency line) according to Embodiment 3 of the present invention. In Fig. 9, reference numeral 41 denotes a semiconductor substrate (a dielectric); 42 denotes a grounding conductor formed on the underside of the semiconductor substrate 41; 43 denotes an insulator (a first insulator) formed on the top of the semiconductor substrate 41 and having an effective dielectric constant higher than that of the semiconductor substrate 41; 44 denotes a groove cut in the top of the insulator 43; 45a, 45b and 45c denote strip conductors formed on the groove 44 to a predetermined thickness; 46a and 46b denote insulators (second insulators) interposed between the strip conductors 45a and 45b and between the strip conductors 45b and 45c, respectively; and 47 denotes generally a laminate composed of the strip conductors 45a, 45b, 45c and the insulators 46a, 46b laminated alternately with each other. Since the groove 44 is concavely curved, the upper and lower edges of the strip conductors 45a, 45b, 45c and the insulators 46a, 46b, which are formed by etching or similar printing process, are also similarly curved; that is, the laminate 47 has such a concave configuration that the distance between its central surface area and the grounding conductor 42 is shorter than the distance between marginal portions of the laminate 47 and the grounding conductor 42.

Next, the operation of this embodiment will be described below. By alternate lamination of the strip conductors 45a, 45b, 45c and the insulators 46a, 46b for their electromagnetic coupling to form the laminate 47 as shown in Fig. 9, the laminate 47 can be handled equivalently as one strip conductor. This structure suppresses centering of high-frequency current due to the skin effect in the strip conductors 45a, 45b and 45c, permitting reduction of the conductor loss related to the strip conductors 45a, 45b and 45c. Incidentally, the thicknesses of the strip conductors 45a, 45b, 45c and the insulators 46a, 46b are set to sufficiently small values than the skin depth with a view to suppressing the skin effect.

Further, since end faces and corner portions of the laminate 47 regarded equivalently as one strip conductor can be formed approximately curved as depicted in Fig. 9 by suitably selecting the widths of the strip conductors 45, 45b, 45c and the insulators 46a, 46b to be laminated alternately with each other, it is possible to suppress the emanation of electric lines of force at the marginal end portions of the strip conductors 45a, 45b and 45c, thus reducing the transmission loss.

As described above, according to Embodiment 3, since the microstrip line is composed of the semiconductor substrate 41, the grounding conductor 42 formed underside of the semiconductor 41, the insulator 43 formed on the top of the semiconductor substrate 41 and having an effective dielectric constant higher than the dielectric substrate 41, and the laminate 47 formed by alternately laminating the strip conductors 45a, 45b, 45c and the insulators 46a, 46b on the groove formed in the top of the insulator 43, it is possible to suppress centering of the high-frequency current due to the skin effect in the strip conductors 45a, 45b and 45c, reducing the conductor loss related to the strip conductors 45a, 45b and 45c. Moreover, since end faces and corner portions of the laminate 47 that can be handled equivalently as one strip conductor can be formed approximately curved by suitably selecting the widths of the strip conductors 45, 45b, 45c and the insulators 46a, 46b to be laminated alternately with each other, it is possible to suppress the emanation of electric lines of force at the marginal end portions of the strip conductors 45a, 45b and 45c, thus reducing the transmission loss.

### EMBODIMENT 4

Fig. 10 is a cross-sectional view showing the construction of a microstrip line (a high-frequency line) according to Embodiment 4 of the present invention. In Fig. 10, the same reference numerals as those in Fig. 9 denote parts identical with or corresponding to those in the latter, and no description will be repeated. Reference numerals 48a, 48b and 48c denote through holes through which the strip conductors 45a, 45b and 45c are electrically interconnected.

Next, the operation of this embodiment will be described below. By electrically interconnecting the strip conductors 45a, 45b and 45c with the insulators interposed between them, the distribution of the high-frequency current in the microstrip line can be optimized. Incidentally, such parameters as the number, positions and diameters of the through holes 48a, 48b and 48c are set by the use of an electromagnetic field simulator or the like so as to provide the optimum distribution of the high-frequency current.

As described above, according to Embodiment 4, the same effect as obtainable with Embodiment 3 can be produced, and since the strip conductors 45a, 45b and 45c forming the laminate 47 are electrically interconnected through the through holes 48a, 48b and 48c, it is possible to optimize the current distribution of the high-frequency current flow in the strip conductors 45a, 45b and 54c forming the laminate 47, thereby reducing the conductor loss.

### EMBODIMENT 5

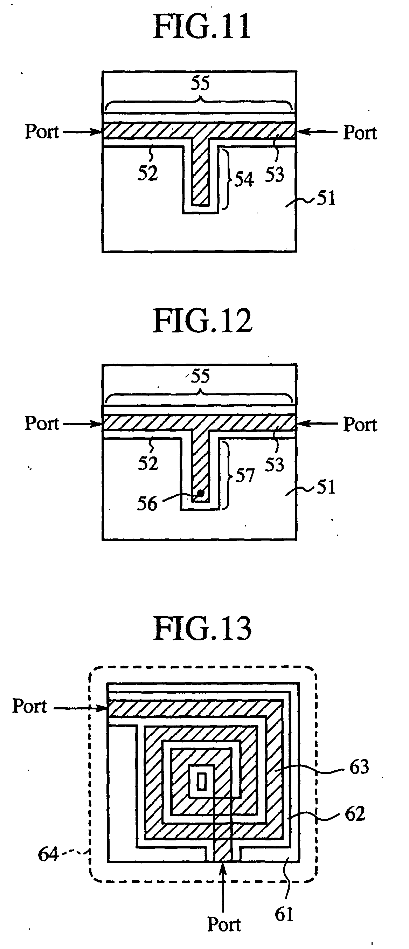

Fig. 11 is a plan view showing an example of a high-frequency circuit according to Embodiment 5 of the present invention. The high-frequency circuit according to Embodiment 5 is a high-frequency circuit that is equipped with a stub using the microstrip line according to any one of Embodiments 1 to 4 and has a capacitive or inductive frequency characteristic. Reference numeral 51 denotes a semiconductor substrate; 52 denotes an insulator formed on the upper side of the semiconductor substrate 51 and having an effective dielectric constant higher than that of the semiconductor substrate 51, or an insulator part formed of a plurality of such insulators; and 53 denotes a strip conductor formed on a groove formed in the insulator or insulator part or a laminate composed of pluralities of strip conductors and insulators. Reference numeral 54 denotes an open-circuit stub (a stub) formed by the microstrip line according to any one of Embodiments 1 to 4, and 55 denotes a main a main line formed by the microstrip line according to any one of Embodiments 1 to 4 to interconnect ports. Next, the operation of this embodiment will be described below. By connecting the open-circuit stub 54 to the main line 55 as depicted in Fig. 11, a high-frequency circuit is formed which has a capacitive or inductive frequency characteristic according to frequency. With the use of the microstrip line according to any one of Embodiments 1 to 4 as each of the main line 55 and the open-circuit stub 54, it is possible to obtain a low-loss high-frequency circuit that has a capacitive or inductive frequency characteristic.

Fig. 12 is a plan view showing another example of the construction of the high-frequency circuit according to Embodiment 5 of the present invention. In Fig. 12 the same reference numerals as those in Fig. 11 denotes parts identical with or corresponding to those in the latter; no description will be repeated: Reference numeral 56 denotes a through hole, and 57 a short-circuit stub (a stub) formed by the microstrip line according to any one of Embodiments 1 to 4. By connecting the short-circuit stub 57 to the main line 55 as depicted in Fig. 12, too, a low-loss high-frequency circuit can be obtained which has a capacitive or inductive frequency characteristic.

As described above, according to Embodiment 5, since the main line 55 and the stub 54 or 57, which are each formed by the microstrip line according to any one of Embodiments 1 to 4 of the present invention, are connected to form a high-frequency circuit, it is possible to obtain a low-loss high-frequency circuit that has a capacitive or inductive frequency characteristic. Further, when applied to such high-frequency devices as a high-frequency amplifier and a high-frequency oscillator, the high-frequency circuit according to Embodiment 5 will improve their noise characteristic.

### EMBODIMENT 6

Fig. 13 is a plan view showing an example of the construction of a high-frequency circuit according to Embodiment 6 of the present invention. The high-frequency circuit according to Embodiment 6 features the formation of a spiral inductor by using the microstrip line according to any one of Embodiments 1 to 4 of the present invention. In Fig. 13, reference numeral 61 denotes a semiconductor substrate; 62 denotes an insulator or insulator part formed on the top of the semiconductor substrate 61 and having an effective dielectric constant than that of the semiconductor substrate 61; and 63 denotes a strip conductor or laminate provided in a groove formed in the insulator or insulator part 62. Reference numeral 64 denotes generally a spiral inductor that interconnects ports by using the microstrip line according to any one of Embodiments 1 to 4 of the present invention.

As described above, according to Embodiment 6, since the spiral inductor 64 is formed using the microstrip line according to any one of Embodiments 1 to 4, it is possible to obtain a low-loss spiral inductor. Further, when applied to such high-frequency devices as a high-frequency amplifier and a high-frequency oscillator, the spiral inductor according to Embodiment 5 will improve their noise characteristic.

### INDUSTRIAL APPLICABILITY

As described above, the present invention lends itself to the fabrication of low-loss high-frequency line and high-frequency circuit that are applied to such high-frequency devices as a high-frequency amplifier and a high-frequency oscillator.

## Claims

1. A high-frequency line **characterized by** the provision of: a dielectric; a grounding conductor formed on the underside of said dielectric; an insulator formed on the top of said dielectric and having an effective dielectric constant higher than that of said dielectric; and a strip conductor formed in a groove formed in the top of said insulator and having a concavely curved configuration that the central surface area of said strip conductor is lower than its marginal portions.

2. A high-frequency line **characterized by** the provision of: a dielectric; a grounding conductor formed on the underside of said dielectric; a plurality of flat insulators of different dielectric constants higher than that of said dielectric and laminated in stepwise form on the top of said dielectric to form a groove; and a strip conductor provided in the groove defined by said plurality of insulators and having a concavely curved configuration that the central surface area of said strip conductor is lower than its marginal portions.

3. A high-frequency line **characterized by** the provision of: a dielectric; a grounding conductor formed on the underside of said dielectric; one or more first insulators formed on the top of said dielectric and having an effective dielectric constant higher than that of said dielectric; and a laminate formed concavely curved in its entirety by alternately laminating pluralities of strip conductors and second insulators in a groove formed in the top of said first insulator.

4. The high-frequency line according to claim 3, **characterized by** the provision of one or more through holes for electrically interconnecting the plurality of strip conductors forming the laminate.

5. A high-frequency circuit **characterized by** the interconnection of a main line formed using the high-frequency line recited in claim 1 and one or more stubs each formed by said high-frequency line.

6. A high-frequency circuit **characterized by** the interconnection of a main line formed using the high-frequency line recited in claim 2 and one or more stubs each formed by said high-frequency line.

7. A high-frequency circuit **characterized by** the interconnection of a main line formed using the high-frequency line recited in claim 3 and one or more stubs each formed by said high-frequency line.

8. A high-frequency circuit **characterized by** the interconnection of a main line formed using the high-frequency line recited in claim 4 and one or more stubs each formed by said high-frequency line.

9. A high-frequency circuit **characterized by** the provision of a spiral inductor formed using the high-frequency line recited in claim 1.

10. A high-frequency circuit **characterized by** the provision of a spiral inductor formed using the high-frequency line recited in claim 2.

11. A high-frequency circuit **characterized by** the provision of a spiral inductor formed using the high-frequency line recited in claim 3.

12. A high-frequency circuit **characterized by** the provision of a spiral inductor formed using the high-frequency line recited in claim 4.
